# EUROPEAN PATENT APPLICATION

(11) **EP 3 816 559 A1**
(43) Date of publication of application: **05.05.2021**
(21) Application number: 19206017.6
(22) Date of filing: 29.10.2019
(51) Int. Cl.: F28D 15/02, F28D 15/04, H01L 23/427, H05K 7/20

(54) **TWO-PHASE HEAT TRANSFER DEVICE FOR HEAT DISSIPATION**

(71) Applicant: ABB Schweiz AG, 5400 Baden (CH)
(72) Inventor: Petrov, Andrey, 8048 Zürich (CH); Jacimovic, Jacim, 5430 Wettingen (CH); Boehm, Moritz, 5507 Aargau (CH); Agostini, Bruno, 8006 Zürich (CH); Torresin, Daniele, 5400 Baden (CH)
(74) Representative: Qip Patentanwälte Dr. Kuehn & Partner mbB

(57) **Abstract**

The invention relates to a two-phase heat transfer device (10) for dissipating heat from a heat source, for instance a power semiconductor module (26), by a heat transfer medium, wherein the two-phase heat transfer device (10) comprises a main body (12), wherein the main body (12) is formed by a body material (14) and comprises a multi-dimensional void network (16), wherein the multi-dimensional void network (16) comprises voids and is adapted for containing the heat transfer medium, wherein the multi-dimensional void network (16) is adapted such that a flow of the heat transfer medium along a path (20) through the main body (12) is based on a variation in capillary action exerted by the multi-dimensional void network (16) on the heat transfer medium along the path (20). Further the invention relates to a power semiconductor module (26) comprising the above two-phase heat transfer device (10) for heat dissipation and to a method for producing the above two-phase heat transfer device (10).

## Description

### Technical Field

The present invention relates to a two-phase heat transfer device for dissipating heat from a heat source, for instance, a power semiconductor module, by a heat transfer medium. The present invention particularly relates to a two-phase heat transfer device comprising a main body, wherein the main body is formed by a body material and comprises a multi-dimensional void network. The present invention also relates to a power semiconductor module comprising the above two-phase heat transfer device. Furthermore, the present invention relates to a method for producing the above two-phase heat transfer device.

### Background Art

Power semiconductor modules are generally widely known in the art. Conventional power semiconductor modules are complex assemblies comprising many different components, each dedicated to perform a specific function. Electric circuits and/or power semiconductor devices of the power semiconductor module may produce heat which needs to be dissipated by a heat transfer device in order to maintain the functionality of the power semiconductor module. There are different techniques in order to dissipate heat away from the heat source, such as bringing the heat source into contact with a heat sink that may be provided as a cooler with a coolant flow.

However, advances in the development of power semiconductor modules are directed towards high current densities and dense packaging of the power semiconductor modules and, thus, efficient cooling and/or heat dissipation becomes even more important. Conventional heat transfer devices as heat sinks, heat pipes, and vapor chambers may not be able to meet the requirements on freedom of design of the heat transfer device, thermal resistance and dissipated heat flux.

US 2017/0235349 A1 describes a 3D printed thermal management device that includes a single contiguous component including at least a portion of a first heat exchanger and at least a portion of a second heat exchanger. The second heat exchanger is of a different type than the first heat exchanger.

However, the prior art such as referring to the above cited reference still gives room for improvements especially regarding the freedom of design, the dissipated heat flux, and the mechanical stability of the heat transfer device and in turn the reliability and lifetime of the power semiconductor module.

### Summary of invention

It is therefore an object of the invention to provide a reliable heat transfer device with an increased heat dissipation for a heat source, for example a power semiconductor module, and a method for producing the heat transfer device.

This object is addressed by a two-phase heat transfer device having the features of independent claim 1. This object is further addressed by a power semiconductor module having the features of independent claim 10. Furthermore, this object is addressed by a method for producing the above two-phase heat transfer device having the features of independent claim 12. Advantageous embodiments are given in the dependent claims, in the further description as well as in the Figures, wherein the described embodiments can, alone or in any combination of the respective embodiments, provide a feature of the present invention unless not clearly excluded.

Described is a two-phase heat transfer device for dissipating heat from a heat source by a heat transfer medium, wherein the two-phase heat transfer device comprises a main body, wherein the main body is formed by a body material and comprises a multi-dimensional void network, wherein the multi-dimensional void network comprises voids and is adapted for containing the heat transfer medium, and wherein the multi-dimensional void network is adapted such that a flow of the heat transfer medium along a path through the main body is based on a variation in capillary action exerted by the multi-dimensional void network on the heat transfer medium along the path.

Such a two-phase heat transfer device provides significant advantages over solutions of the prior art, especially with regard to a higher freedom of design, mechanical stability and maximum dissipated heat flux of the two-phase heat transfer device. Therefore, the two-phase heat transfer device may provide a more reliable and efficient cooling of the heat source. When using the two-phase heat transfer device to dissipate heat from a power semiconductor module, the reliability and lifetime of the power semiconductor module is enhanced.

The present invention thus refers to a two-phase heat transfer device for transferring heat by the heat transfer medium away from the heat source. Two-phase heat transfer device in this context means that the heat is transferred at least in part by a phase transition of the heat transfer medium. Preferably, a working mechanism of the heat transfer device at least partly relies on the phase transition of the heat transfer medium from liquid to gaseous and vice versa.

Two-phase heat transfer devices which are based on phase transition are known in the prior art as heat pipes or vapor chambers. Conventional heat pipes and/or vapor chambers usually comprise a closed pipe or a closed chamber containing saturated liquid and its gas phase as heat transfer medium and a wick structure. At a hot end of the heat transfer device, i.e. near the heat source, the saturated liquid vaporizes and travels to a cool end of the heat pipe, where the gas phase condensates and turns back to saturated liquid. In a conventional heat pipe and/or vapor chamber, the condensed liquid is returned to the hot end using the wick structure exerting a capillary action on the liquid phase of the heat transfer medium. The wick structure may have a series of grooves that are reliable for the capillary action. The capillary action is essentially the same in all locations of the wick structure. However, since the capillary action is essentially the same in all locations of the wick structure a direction of flow is solely imposed on the liquid heat transfer medium by a pressure difference between the hot and the cold end. This may make the flow of the liquid heat transfer medium back to the hot end inefficient due to several reasons like insufficient permeability of the wick structure or negative gravity effect, when it is opposed to the intended direction of the flow of the liquid heat transfer medium. Furthermore, in conventional heat pipes and/or vapor chambers the wick structure may be formed from sintered metal powder or sintered screen mesh or metal fiber, which are normally diffusion bonded to the parts of the vapor chamber closure, like evaporator, condenser, pillars and side walls. The latter are then joined into a single piece by a variety of techniques like stamping, brazing, ultrasonic or diffusion bonding. This makes conventional heat pipes and/or vapor chambers difficult to manufacture due to the presence of large areas of weak joints and issues with preserving porous wick continuity, which is important for correct circulation of the liquid phase inside the heat pipe and/or vapor chamber. In particular, conventional manufacturing methods may only offer a limited freedom of design and may not allow to control the shape, porosity, and/or further properties of the wick structure accurately enough to achieve high cooling efficiencies of the two-phase heat transfer device. Besides, the large areas of weak joints and/or diffusion bonded joints may impose stability issues and may constrain the maximum allowable pressure in the heat pipe or vapor chamber, thus reducing its upper working temperature limit.

These problems of the prior art may be addressed by the present invention. The two-phase heat transfer device of the present invention comprises the main body formed by the body material. The main body comprises the multi-dimensional void network. The multi-dimensional void network comprises the voids and is adapted for containing the heat transfer medium. The voids may be holes, pores and/or pipes in the main body. The body material of the main body may have a porous structure for forming the multi-dimensional void network. In other words, the voids may be structures in the main body which are free of the body material. The holes, pores and/or pipes thus form the multi-dimensional void network. The multi-dimensional void network may be embedded in the body material. The multi-dimensional void network or the voids thereof, respectively, may be interconnected or partially interconnected. For example, there may be a hole in the main body, which is directly next to a tube, wherein there is no body material in between the said hole and said tube. Thus, the hole and the tube may form one continuous hollow space in the main body. The term "partially interconnected" indicates that there may be an additional void that may not have an interconnection to another void. Instead, said void may be enclosed by the body material.

The multi-dimensional void network is adapted for containing the heat transfer medium, preferably meaning that the liquid and gaseous phase of the heat transfer medium can be contained in the multi-dimensional void network or the voids thereof, respectively, and may in its liquid phase flow through the multi-dimensional void network and/or in its gaseous phase spread through the multi-dimensional void network.

The multi-dimensional void network is adapted such that the flow of the heat transfer medium, in particular the flow of the heat transfer medium in its liquid phase, along the path through the main body is based on the variation in capillary action exerted by the multi-dimensional void network on the heat transfer medium along the path. Compared to conventional heat transfer devices of the prior art, the two-phase heat transfer device of the present invention has the multi-dimensional void network adapted such that the capillary action is not the same in all locations of the multi-dimensional void network, but such that the capillary action varies along the path through the main body. The path through the main body is preferably a path through the main body within the multi-dimensional void network, since the heat transfer medium is contained in the multi-dimensional void network. However, beside this constrain, the path through the main body may be any path. Preferably, it may be a path through the main body connecting a hot end of the two-phase heat transfer device with a cool end of the two-phase heat transfer device. In other words, the path may connect a location near the heat source, e.g. a hotspot of the power semiconductor module with a location near a heat sink. Due to the variation in capillary action along the path the direction of flow of the heat transfer medium in its liquid phase through the main body may be controlled. Furthermore, the flow rate of the heat transfer medium in its liquid phase through the main body may be controlled. Thus, the two-phase heat transfer device may have an enhanced heat dissipation efficiency, since the flow of the liquid heat transfer medium to the hot end may be additionally supported by the varying capillary action. In other words, the direction of flow and/or the flow rate of the liquid heat transfer medium towards the hot end of the two-phase heat transfer device is not only due to fact that at the hot end the portion of heat transfer medium in the liquid phase is lower than at the cool end, which produces the driving force in the form of the pressure difference, but also due to the changing capillary actions along the path. The change in capillary action along the path may not only lead to a change in capillary force along the path but also to a change in permeability along the path.

Preferably, the variation in capillary action exerted by the multi-dimensional void network on the heat transfer medium along the path is such that the capillary action at one end of the path is different to the capillary action at the opposite end of the path. Furthermore, the variation in capillary action may be step like or in a gradual manner. Preferably, the variation in capillary action exerted by the multi-dimensional void network on the heat transfer medium along the path is such that the derivative of the capillary action along the path has a constant sign. In other word, this may mean that the capillary action along a specific direction along the path may decrease along this direction along the path, or that the capillary action may increase along this direction along the path. However, it may not decrease and increase along this direction along the path simultaneously.

Furthermore, the expression multi-dimensional void network may mean that the network formed by the voids extends in one dimension of space, preferably in two dimensions of space, or more preferably in three dimensions of space. Thus, the multi-dimensional void network may be a one-dimensional network, preferably a two-dimensional network, or more preferably a three-dimensional network. The multi-dimensional void network therefore offers the possibility to adapt the path through the main body to the specific cooling needs. In other words, the multi-dimensional void network allows to control the circulation of the heat transfer medium on a local scale by the enhanced freedom of design.

With regard to the enhanced freedom of design and according to a preferred embodiment a two-phase heat transfer device may be provided, wherein the main body is formed in an additive manufacturing process and/or the main body is formed as one-piece component. Additive manufacturing which is also called layer by layer manufacturing may designate a process where the desired shape of the main body is not produced by removing material, but by adding material in successive layers. In such processes, the body material may be joined or solidified to create a multi-dimensional object, i.e. the main body as one-piece component. Using layer by layer manufacturing allows producing complex multi-dimensional shapes and structures with a high precision. Therefore, the two-phase heat transfer device, the main body and the multi-dimensional void network in the main body may be easily and precisely produced. The additive manufacturing process offers eased producibility, since there may be no brazing and/or sintering and/or diffusion bonded interfaces within the main body of the two-phase heat transfer device. Furthermore, the main body as one-piece component may have a higher stability due to the lack of brazing and/or sintering interfaces within the main body of the two-phase heat transfer device. Hence, the producibility, stability, performance and lifetime of the two-phase heat transfer device may be enhanced.

With regard to the variation in capillary action along the path, several implementation possibilities may be conceivable. The capillary action may be based on intermolecular forces between the heat transfer medium inside the voids and the surrounding surface of the body material. The capillary action may change with the geometry and/or volume of the void or with the geometry and/or volume the multi-dimensional void network, respectively. According to the above, a two-phase heat transfer device may be provided, wherein the voids are arranged in the main body such that a variation of density and/or porosity of the body material and/or main body is achieved along the path through the main body. This may be an easy way to achieve a variation of capillary action along the path. The density of the body material and/or main body may be the particle density, the bulk density, and/or the packing density. The particle density, also called true density of the main body, may be the density of the body material, that makes up the main body, in other word the density of the main body measured without the volume of the voids. In contrast, the bulk density of the main body may measure the density of the main body including the volume of the voids. The packing density may be the ratio between the volume of the body material and the volume of the voids. The porosity is the ratio between the volume of voids and the volume of the main body. Preferably, the porosity may vary within a range of 10% to 80%. By controlling one or more of these properties - density and porosity - the capillary action may be influenced and a variation in capillary action along the path may be achieved. For example, the voids may be distributed in the main body with a varying inter void distance and therefore one or more of the above properties may vary along the path through the main body.

Alternatively or additionally, the geometry and/or volume of the voids may change along the path through the main body.

The invention also allows for changing a size of the voids. Preferably, the size of the voids is defined by the diameter of the voids forming the multi-dimensional void network. The voids may have a tubular pipe-like form with circular or rectangular cross-section shape, or more complex cross-section shape, like a cross or a polygon. For example, the respective void or voids may have the form of a pipe being defined by its length and its diameter, with the diameter being smaller than the length. The diameter of the pipe may be equal to or smaller than 200 µm, for example 150 µm. This does not exclude that there may be another size of the voids that may be larger than 200 µm. For example, the length of the pipe may be in the range between 1 mm to 300 mm. By changing the geometry and/or volume of the voids also a diameter and thus a size of the voids may change. According to this, a two-phase heat transfer device may be provided wherein the voids have sizes in a first size range, and wherein the voids are arranged in the main body such that a variation of the size of the voids is achieved along the path through the main body. In other words, the voids of the multi-dimensional void network may not all have the same size, but may have different sizes. Considering all different sizes of the voids, the sizes may lie in the first size range. Preferably, the first size range may lie between 5 µm to 200 µm, more preferably between 20 µm to 150 µm. Arranging the voids with different sizes along the path such that a change in size of the voids along the path is achieved, may be an easy way to result in a variation of capillary action along the path.

As already mentioned above, the variation in capillary action exerted by the multi-dimensional void network on the heat transfer medium along the path is preferably such that the derivative of the capillary action along the path has a constant sign. In this regard, a two-phase heat transfer device may be provided wherein the variation of density, the variation of porosity and/or the variation of the size along the path is such that the derivative of the density, porosity and/or size along the path has a constant sign. Beside and according to a preferred embodiment of the invention, a two-phase heat transfer device is provided wherein the variation of density, the variation of porosity and/or the variation of the size along the path comprises a continuous and/or discontinuous variation. The term "continuous variation" means that the above properties may change gradually along the path. This may lead to an increased control of the flow, flow direction and/or flow rate of the heat transfer medium along the path. However, from a standpoint of manufacturing it may be easier to implement a discontinuous variation of the above properties along the path. The term "discontinuous variation" means that the above properties change in a step like manner along the path. For example, there may be a fist section of the path, where the porosity of the main body has a certain magnitude and in an adjoining section of the path the porosity has a different magnitude.

With regard to the variation of density, the variation of porosity and/or the variation of the size along the path, the density, the porosity and/or the size of the void may be described by a mathematical function depending on at least two parameters. Preferably the mathematical function depends on two parameters. Expressed in a mathematical formula, the mathematical function may be v = f(x,y), or preferably v = f(x,y,z), wherein v is the density, the porosity and/or the size of the void and x, y and z are the parameters. The parameters may be positional parameters, that may dedicate the position of a point in a two- or three-dimensional coordinate system for example along the path through the main body. In particular, the mathematical function f(x,y,z) describing the density, the porosity and/or the size of the void for a three-dimensional object as the main body may be a mathematical function having a certain symmetry. For example, the function f(x,y,z) may be a function of an ordered lattice, e.g. a quadratic or hexagonal lattice. Alternatively, it may be a function of a stochastic foam, or a minimal surface, for example a Schwarz D, Gyroid. Such an arrangement of voids in the main body forming the multi-dimensional void network may increase the heat dissipation of the two-phase heat transfer device and may ease producibility.

With regard to the sizes of the voids, a two-phase heat transfer device may be provided wherein the voids have sizes in a first size range and the voids have sizes in a second size range, and wherein a size distribution of the voids shows at least two distinct maxima. In other words, the voids of the multi-dimensional void network may not all have the same size, but may have different sizes. Considering all different sizes of the voids, the sizes may lie in two or more size ranges, i.e. in a first size range and in a second size range. Preferably, the first size range may lie between 5 µm to 200 µm, more preferably between 20 µm to 150 µm. Preferably, the second size range may lie between 75 µm to 2000 µm, more preferably between 100 µm to 500 µm. Hence, the first size range and second size range and all consecutive size ranges may overlap. However, the size distribution preferably shows at least two distinct maxima, preferably one maximum in the first size range and the other maximum in the second size range. By having voids with sizes in two size ranges with two distinct maxima in the size distribution, the two-phase heat transfer device may show an enhanced heat dissipation efficiency. The first size range may control the direction of the flow of the heat transfer medium along the path based on the variation in capillary action, as mentioned above. The second size range, with voids having on average a larger size, may increase the flow rate of the liquid phase and may also reduce vapor resistance flow rate. Furthermore, having voids with sizes in the second size range may increase the overall cooling efficiency of the two-phase heat transfer device.

With regard to the heat transfer medium and according to a preferred embodiment the heat transfer medium may comprise water, ammonia, methanol, ethanol, isopropanol, ethylamine, pentane, acetone and/or a refrigerant fluid. The refrigerant fluid may be one of the refrigerant fluids which has an ASHRAE designated number for example R123 and/or R1233zd. The American Society of Heating, Refrigerating and Air-Conditioning Engineers (ASHRAE) assigns an R number which is determined systematically according to the molecular structure of the refrigerant fluid. The heat transfer medium may be chosen according to the temperature at which the two-phase heat transfer device may operate. It may be one of the above compounds or it may be a mixture thereof. Since the main body of the two-phase heat transfer device preferably is formed in an additive manufacturing step and/or the main body is formed as a one-piece component, the two-phase heat transfer device is very robust. Therefore, high pressure heat transfer media, as ammonia, may be used, which in turn may enhance the heat flux of the two-phase heat transfer device.

Furthermore, the heat transfer medium may be chosen under consideration of the properties of the body material of the main body. In this context, and according to a preferred embodiment the body material may comprise a compound or a mixture thereof selected from the group comprising copper, bronze, brass, CuCrZr, CuNiSi(Cr), 1xxx/2xxx/6xxx series aluminum, AISi7Mg, AISi10Mg, AISi12, Scalmalloy, Al6061, A20X, Al-Cu, titanium, Ti6Al4V, steel 316L, steel 17-4PH, Inconel 618, Inconel 725, maraging steel. The body material may not be limited to metal alloys. Accordingly, the body material may comprise a compound or a mixture thereof selected from the group comprising plastics, resins like ABS, PLA, PET, PP and/or a composite material like carbon-fiber or metal-reinforced plastic/resin. The body material and hence the main body may have good heat conducting properties. Therefore, improved heat dissipation by the two-phase heat transfer device may be achieved. The body material may be provided with or without a sintering additive like, for instance, an alkali additive or with or without a binder. Furthermore, the body material may be compatible for use in the additive manufacturing step.

As already mentioned above, the multi-dimensional void network is adapted for containing the heat transfer medium. In this regard a two-phase heat transfer device may be provided wherein the main body comprises a closure, and wherein the closure is based on the body material and impermeable for the heat transfer medium. The closure may be an outer surface of the main body. Furthermore, the closure may be a structure within the main body or extending through the main body. The closure may have any form, in particular a from that is adapted to the cooling needs of the heat source, for example the power semiconductor module. Preferably, the closure has a multi-dimensional form, in particular the closure may extend in three dimensions. Preferably, the closure has an enclosed form, such that the heat transfer medium may be contained within the closure. More preferably, the multi-dimensional void network may be arranged within the closure. However, the multi-dimensional void network embedded in the main body and the closure may not be two separate components. In other word, there may be no sintering, diffusion bonding and/or brazing interface between the closure and the body material forming the multi-dimensional void network. On the contrary, the main body comprising the multi-dimensional void network and the closure preferably are a one-piece component formed by the body material. The body material may have a porous structure for forming the multi-dimensional void network. Furthermore, the body material may have a dense structure for forming the closure. The density of the body material may be > 95% for the closure. For example, the closure may be formed by compacting the body material such that it is impermeable for the heat transfer medium. Furthermore, the closure may be produced using a set of laser parameters, different from the set of parameters used to produce the multi-dimensional void network within the main body. Furthermore, the closure may be produced by infiltrating an exterior layer of the multi-dimensional void network within the main body with a non-permeable material. Thus, there may be a continuous transition between the closure and the body material in which the multi-dimensional void network is embedded. This may enhance the stability of the two-phase heat transfer device.

With regard to further advantages and technical features of the two-phase heat transfer device, it is referred to the power semiconductor module, the method for producing the two-phase heat transfer device, the Figures, and the further description.

The present invention further relates to a power semiconductor module comprising a two-phase heat transfer device as described above for heat dissipation. Such a power semiconductor module provides significant advantages over conventional solutions, especially with regard to cooling efficiency, reliability, freedom of design and lifetime of the power semiconductor module. The two-phase heat transfer device of the power semiconductor module may transfer the heat from the heat source to a heat sink in a very efficient manner. Furthermore, the freedom of design offered by the multi-dimensional void network allows to adapted the form of the multi-dimensional void network to the cooling needs of the power semiconductor module. Hence, the risk of dry-outs, i.e. local regions in the two-phase heat transfer device that may contain no liquid phase of the heat transfer medium due to local hot spots, may be reduced.

The power semiconductor module may comprise a power semiconductor device as heat source. According to this a power semiconductor module may be provided wherein the two-phase heat transfer device is adapted for dissipating heat from the power semiconductor device. In other words, there may be an adapted design of the two-phase heat transfer device, in particular of the multi-dimensional void network to the power semiconductor device of the power semiconductor module. It may be possible that the two-phase heat transfer device is integrated in a specific part of the power semiconductor module, e.g. a baseplate having one side that is configured to provide the power semiconductor devices. Further, the two-phase heat transfer device may be integrated directly into the packaging of the power semiconductor device. With regard to the multi-dimensional void network, the voids may be arranged such that heat may be transferred away from the power semiconductor device in all three dimensions. For example, the path through the main body may lead from the power semiconductor device as heat source away to a cooling structure, for example heat fins. Preferably, there is more than one path leading away from the heat source. Therefore, the heat dissipation may be intensified. Furthermore, the variation in capillary action along the path may be adapted according to specific cooling needs of the power semiconductor device.

With regard to further advantages and technical features of the power semiconductor module, it is referred to the two-phase heat transfer device, the method for producing the two-phase heat transfer device, the figures, and the further description.

The present invention further relates to a method for producing the above described two-phase heat transfer device. The method comprises the step of forming a main body from a body material, wherein the main body comprises a multi-dimensional void network, wherein the multi-dimensional void network comprises voids and is adapted for containing a heat transfer medium, wherein the main body is formed such that a flow of the heat transfer medium along a path through the main body is based on a variation in capillary action exerted by the multi-dimensional void network on the heat transfer medium along the path.

It may be provided that the main body of the two-phase heat transfer device is produced is produced by using an additive manufacturing process and/or the main body is formed as one-piece component. Additive manufacturing, which is also called layer by layer manufacturing is a process where the desired shape of the main body is not produced by removing material but by adding material in successive layers. In such processes, a feedstock material comprising the body material may be joined or solidified to create a multi-dimensional object, i.e. the main body and thus the two-phase heat transfer device comprising the multi-dimensional void network. Using layer by layer manufacturing allows producing complex multi-dimensional shapes and structures with a high precision

With regard to layer by layer manufacturing, for example, powder bed fusion additive manufacturing technique may be used. Powder bed fusion additive manufacturing may designate a process in which thermal energy, for example from a laser or an electron beam, selectively fuses regions of a powder bed. For example, selective laser melting may be used. Furthermore, directed energy deposition as additive manufacturing process may be used in which focused thermal energy may fuse materials by melting them as they are being deposited. Further, material extrusion may be used. In this technique, a feedstock material, i.e. the body material and optionally a binder material may be pushed through an extruder. For example, a metal slurry that may comprise varying amounts of binder mixture may be used as feedstock material. Further, binder jetting additive manufacturing technique may be used. It may further be provided that screen printing layer by layer manufacturing technique may be used. In screen printing a layer of body material in a form of powder or slurry is deposited through a mask ("screen") and is then bonded to the previous layer by pressing/heat treatment/UV light curing etc. Multiple masks may be used to achieve the desired complexity of the part.

Preferably, in the additive manufacturing step the main body is formed such that a flow of the heat transfer medium along the path through the main body is based on a variation in capillary action exerted by the multi-dimensional void network on the heat transfer medium along the path. This may be achieved by varying a production parameter of the additive manufacturing step along the path through the main body. For example, when using selective laser melting a parameter of the laser may be varied, e.g. the energy of the laser beam, laser beam scanning speed, a point distance and exposure time for pulsed laser, and/or laser beam scanpath. When using binder-jetting a ratio of binder to body material of the feedstock material may be varied. In this regard the method may comprise the step of varying the production parameter along the path to achieve a variation of density, a variation of porosity and/or a variation of the size of the voids along the path of the main body.

According to a preferred embodiment the production parameter may be varied according to a mathematical function that depends at least on two parameters. Expressed in a mathematical formula, the mathematical function may be p = f(x,y), wherein p is the production parameter and x and y are the two parameters. The two parameters may be positional parameters, that may dedicate the position of a point in a two-dimensional coordinate system. In the additive manufacturing step, the main body may be produced layer by layer, and since a layer is a two-dimensional object, such a mathematical function may suffice to control the production parameter. However, it may also be possible to use a mathematical function that depends on three or more parameters, p = f(x,y,z) or p = f(*̅n̅*̅).

According to a preferred embodiment the main body may comprise a closure, wherein the closure is based on the body material and impermeable for the heat transfer medium, and wherein the closure is formed in a single manufacturing step together with the multi-dimensional void network of the main body. It may be provided that the multi-dimensional void network and the closure are formed in the additive manufacturing step. Preferably, in the additive manufacturing step the multi-dimensional void network and the closure are produced by varying the production parameter. The body material may have a porous structure for forming the multi-dimensional void network and the body material may have a dense structure for forming the closure. For example, when increasing the energy of the laser beam the porosity of the body material may be decreased and/or the density of the body material may be increased and thus the closure may be produced. Preferably, the closure in the main body may be produced be varying the production parameter according to the mathematical function that depends on at least two parameters. In particular as mathematical function a mathematical function describing an ordered lattice, e.g. a quadratic or hexagonal lattice, a stochastic foam, or a Schwarz minimal surface may be used. These may give increased heat dissipation of the two-phase heat transfer device and may be easy to implement in the production of the main body.

It may be provided that after step a), the method further comprises the step b), wherein step b) comprises filling at least part of the multi-dimensional void network with the heat transfer medium. In this step, the multi-dimensional void network may be infiltrate by the heat transfer medium. This may be supported by the capillary action, positive or negative pressure and/or by heating the heat transfer medium preferably to its boiling point.

With regard to further advantages and technical features of the method for producing the two-phase heat transfer device, it is referred to the two-phase heat transfer device, the power semiconductor module, the figures, and the further description.

To summarize the above, the present invention solves an important object how to increase the heat flux, stability freedom of design and ease of production of the two-phase heat transfer device for the power semiconductor module. In turn the reliability, freedom of design, and lifetime of the power semiconductor module may be enhanced significantly.

Further embodiments and advantages of the method are directly and unambiguously derived by the person skilled in the art from the two-phase heat transfer device and the power semiconductor module as described before.

### Brief description of drawings

These and other aspects of the invention will be apparent from and elucidated with reference to the embodiments described hereinafter. Individual features disclosed in the embodiments can constitute alone or in combination an aspect of the present invention. Features of the different embodiments can be carried over from one embodiment to another embodiment.

In the drawings:
Fig. 1 shows a schematic perspective view of a two-phase heat transfer device according to a first embodiment of the invention;
Fig. 2 shows a schematic view of the two-phase heat transfer device according to another embodiment of the invention;
Fig. 3 shows a schematic view of a power semiconductor module according to another embodiment of the invention; and
Fig. 4 shows a schematic view of a process for producing the two-phase heat transfer device, according to another embodiment of the present invention.

### Description of embodiments

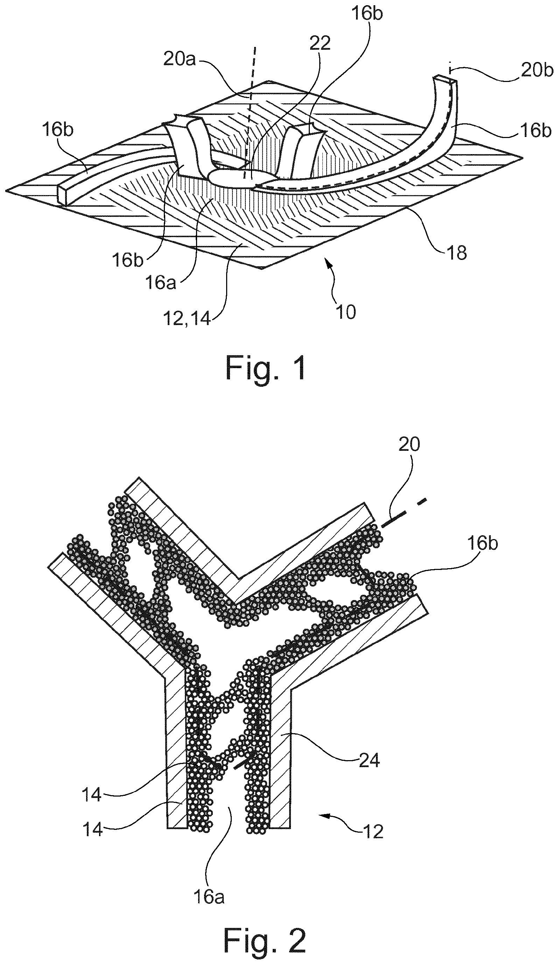

Fig. 1 shows show a schematic perspective view of a of a two-phase heat transfer device 10 according to a first embodiment of the invention.

As can be seen in Figure 1 the two-phase heat transfer device 10 comprises a main body 12, which is formed from a body material 14. In this embodiment the body material 14 comprises pure copper, bronze, brass, CuCrZr, CuNiSi(Cr), 1xxx/2xxx/6xxx series aluminum, AISi7Mg, AlSi10Mg, AISi12, Scalmalloy, Al6061, Al-Cu, pure titanium, Ti6Al4V, steel 316L, steel 17-4PH, Inconel 618, Inconel 725 and/or maraging steel. As can easily be seen in figure 1, the main body 12 comprises a multi-dimensional void network 16, in this embodiment a three-dimensional void network. The multi-dimensional void network 16 is formed by holes, pores and/or pipes in short voids in the main body 12. Within the multi-dimensional void network 16 the main body 12 is free of the body material 14. The body material 14 of the main body 12 has a porous structure for forming the multi-dimensional void network 16. The multi-dimensional void network 16 is adapted for containing a heat transfer medium (not shown in the figures). In figure 1, the main body 12 comprises a base layer 18, also formed by the body material 14. Within the base layer 18, the multi-dimensional void network 16a is formed such that there is a variation in sizes of the voids along a path 20a through the main body 12. The variation is a continuous gradient in void size, and in figure 1 is illustrated by the shading in the base layer 18. In this embodiment the voids of the multi-dimensional void network 16a within the base layer 18 have sizes in a first sizes range from 20 µm to 100 µm, wherein in the center of the base layer 18 the sizes of the voids are smaller than in the outer regions of the base layer 18. By this the capillary action exerted by the multi-dimensional void network 16a on the heat transfer medium varies along a path 20a starting in the center of the base layer 18 and leading outwards.

Furthermore, as can be seen in figure 1 the multi-dimensional void network 16 comprises voids with sizes in a second size range, ranging from 100 µm to 2000 µm. In particular, the voids with sizes in the second size range are arranged such to provide maximum flux of heat transfer medium to the hot spot region 22.

As is also visible in figure 1, the multi-dimensional void network 16 is arranged such that the heat transfer medium flows towards the center of the base layer 18. In other words, this means that in this embodiment the multi-dimensional network 16 is adapted by its three-dimensional shape as well as by its gradient in void size, to the cooling needs of the power semiconductor module (not shown), which has a higher cooling need in a hot spot region 22 near the center of the base layer 18.

In the embodiments shown in figure 2 a detail of the multi-dimensional void network 16 is shown. As is visible form figure 2, the main body 12 comprises a closure 24, which is impermeable for the heat transfer medium. The body material 14 has a dense structure for forming the closure 24. As is also visible in figure 2, the porosity along the path 20 varies. However, in contrast to the embodiment in figure 1, in figure 2 the porosity of the main body 12 does not change gradually along the path 20 but step-like. Shown are three different sections along the path 20, wherein in each section the porosity of the main body 12 has a certain magnitude.

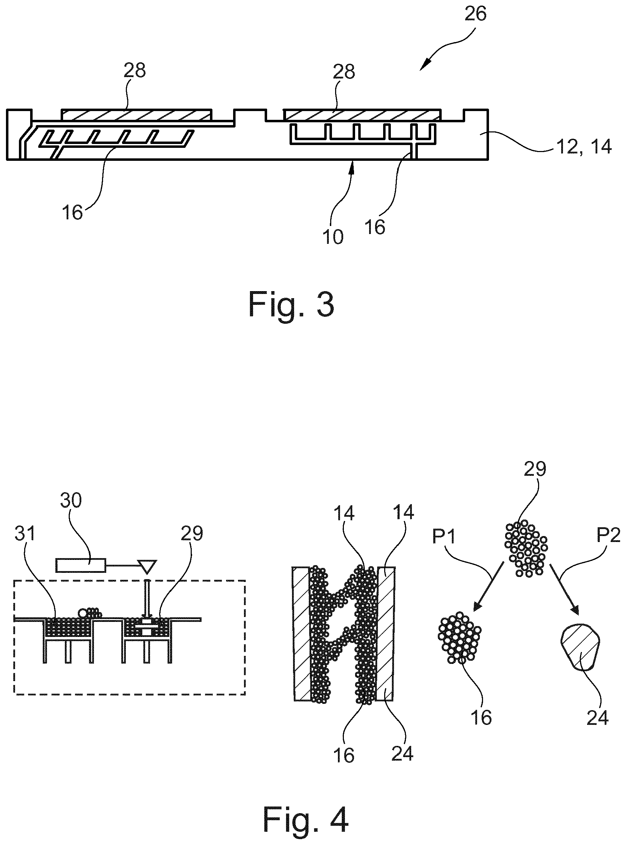

Figure 3 shows not only a schematic view of the two-phase heat transfer device 10, but also of a power semiconductor module 26. The power semiconductor module 26 comprises a power semiconductor device 28 and the two-phase heat transfer device 10. In this embodiment the two-phase heat transfer device 10 is integrated into a baseplate, which carries the power semiconductor device 10 on one side. The multi-dimensional void network 16 of the heat transfer device 10 is adapted to the cooling needs of the power semiconductor module 26 and in particular to its heat source, the power semiconductor device 28.

Figure 4 illustrates the production principles of the two-phase heat transfer device 10. The two-phase heat transfer device 10 is produced by additive manufacturing in this example selective laser sintering. A possible processing method may be as follows: In a first step a main body precursor 29 is produced. A feedstock material 31 comprising the body material 14 is used to produce the main body precursor 29 by means of additive manufacturing. In a subsequent step a laser 30 runs with at least two different settings p1 and p2 of a production parameter, to produce the main body 12 with body material 14 in a porous structure for forming the multi-dimensional void network 16 and with body material 14 in a dense structure for forming the closure 24. When the laser 30 runs with the first setting of the production parameter p1, in this case a low energy setting, the multi-dimensional void network 16 in the main body 12 is formed. When the laser 30 runs with the second setting of the production parameter p2, in this case a high energy setting, the closure 24 is formed. In other words, the production parameter is varied along the path 20 to achieve a variation of density, a variation of porosity and/or a variation of the size of the voids along the path 20 of the main body 12. It may also be possible to have a first production step wherein the closure 24 is produced using the second setting and a subsequent production step wherein the multi-dimensional void network 16 is produced using the first setting. In both cases the main body 12 comprising the multi-dimensional void network 16 and the closure 24 is produced as a one-piece component formed by the body material 14. Further, in some areas, a certain volume of the main body precursor may be excluded from laser exposure at all, to produce a multi-dimensional void network 16 with extra-large pore size with effective diameter greater than 100 µm and, preferably, greater than 300 µm.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: two-phase heat transfer device
- 12: main body
- 14: body material
- 16: multi-dimensional void network
- 18: base layer
- 20: path
- 22: hot spot region
- 24: closure
- 26: power semiconductor module
- 28: power semiconductor device
- 29: main body precursor
- 30: laser
- 31: feedstock material
- p1: first production parameter setting
- p2: second production parameter setting

## Claims

1. Two-phase heat transfer device (10) for dissipating heat from a heat source by a heat transfer medium, wherein the two-phase heat transfer device (10) comprises a main body (12), wherein the main body (12) is formed by a body material (14) and comprises a multi-dimensional void network (16), wherein the multi-dimensional void network (16) comprises voids and is adapted for containing the heat transfer medium,
**characterized in that** the multi-dimensional void network (16) is adapted such that a flow of the heat transfer medium along a path (20) through the main body (12) is based on a variation in capillary action exerted by the multi-dimensional void network (16) on the heat transfer medium along the path (20).

2. Two-phase heat transfer device (10) according to claim 1, **characterized in that** the main body (12) is formed in an additive manufacturing process and/or the main body (12) is formed as one-piece component.

3. Two-phase heat transfer device (10) according to claim 1 or 2, **characterized in that** the voids are arranged in the main body (12) such that a variation of density and/or porosity of the body material (14) and/or main body (12) is achieved along the path (20) through the main body (12).

4. Two-phase heat transfer device (10) according to any of claims 1 to 3, **characterized in that** the voids have sizes in a first size range, wherein the voids are arranged in the main body (12) such that a variation of the size of the voids is achieved along the path (20) through the main body (12).

5. Two-phase heat transfer device according to any of claims 3 or 4, **characterized in that** the variation of density, the variation of porosity and/or the variation of the size along the path (20) comprises a continuous and/or discontinuous variation.

6. Two-phase heat transfer device (10) according to any of claims 1 to 5, **characterized in that** the voids have sizes in a first size range and the voids have sizes in a second size range, and wherein a size distribution of the voids shows at least two distinct maxima.

7. Two-phase heat transfer device (10) according to any of claims 1 to 6, **characterized in that** the heat transfer medium comprises water, ammonia, methanol, ethanol, isopropanol, ethylamine, pentane, acetone and/or a refrigerant fluid.

8. Two-phase heat transfer device (10) according to any of claims 1 to 7, **characterized in that** the body material (14) comprises a compound or a mixture thereof selected from the group comprising copper, bronze, brass, CuCrZr, CuNiSi(Cr), 1xxx/2xxx/6xxx series aluminum, AISi7Mg, AlSi10Mg, AISi12, Scalmalloy, Al6061, A20X, Al-Cu, titanium, Ti6Al4V, steel 316L, steel 17-4PH, Inconel 618, Inconel 725 and/or maraging steel.

9. Two-phase heat transfer device (10) according to any of claims 1 to 8, **characterized in that** the main body (12) comprises a closure (24), wherein the closure (24) is based on the body material (14) and impermeable for the heat transfer medium.

10. Power semiconductor module (26) comprising a two-phase heat transfer device (10) according to any of claims 1 to 9 for heat dissipation.

11. Power semiconductor module (26) according to claim 10, **characterized by** a power semiconductor device (28) and wherein the heat transfer device (10) is adapted for dissipating heat from the power semiconductor device (28).

12. Method for producing a two-phase heat transfer device (10) according to any of claims 1 to 9, comprising the step of
a) forming a main body (12) from a body material (14), wherein the main body (12) comprises a multi-dimensional void network (16), wherein the multi-dimensional void network (16) comprises voids and is adapted for containing a heat transfer medium, wherein the main body (12) is formed such that a flow of the heat transfer medium along a path (20) through the main body (12) is based on a variation in capillary action exerted by the multi-dimensional void network (16) on the heat transfer medium along the path (20).

13. The method according to claim 12, **characterized in that** the main body (12) is produced by using an additive manufacturing process and/or the main body (12) is formed as one-piece component.

14. The method according any of claims 12 or 13, **characterized in that** the main body (12) comprises a closure (24), wherein the closure (24) is based on the body material (14) and impermeable for the heat transfer medium, and wherein the closure (24) is formed in a single manufacturing step together with the multi-dimensional void network (16) in the main body (12).

15. The method according to any of claims 12 to 14, **characterized in that** after step a) the method comprises the further step b), wherein step b) comprises filling at least part of the multi-dimensional void network (16) with the heat transfer medium.
